# EUROPEAN PATENT SPECIFICATION

(11) **EP 0 576 718 B1**
(45) Date of publication and mention of the grant of the patent: **25.09.1996**
(21) Application number: 92111357.7
(22) Date of filing: 03.07.1992
(51) Int. Cl.: B01D 9/00

(54) **Multistage recrystallization for superpurifying crystallizable substances**
Mehrstufige Umkristallisation zum Reinigen kristallisierbare Stoffe
Cristallisation en étapes multiples pour la purification de produits cristallisables

(43) Date of publication of application: 05.01.1994
(73) Proprietor: GRIFFITHS, Kenneth F, Fort Atkinson WI 53538 (US)
(72) Inventor: GRIFFITHS, Kenneth F, Fort Atkinson WI 53538 (US)
(74) Representative: Heunemann, Dieter, Dr.

(56) References cited:
- WO-A-90/01978
- US-A- 3 561 225

## Description

The present invention generally relates to multistage recrystallisation, and more particularly to a multistage recrystallisation method and apparatus for superpurifying crystallizable substances to purify them to extremely high levels, typically on the order of 99.999 percent purity. Reflux ratio conditions are controlled closely, preferably in association with the establishment and maintenance of steady state conditions in each stage of the system, thereby facilitating generally automatic control of reflux ratio conditions by closely monitoring and metering selected material transfers, inputs and/or outputs for each stage of the system.

Purification of crystallizable materials by way of recrystallization techniques has been known and practiced for many years. Generally speaking, it is extremely difficult to remove trace impurities from crystallizable materials by recrystallization from a saturated solution therefor, or by other techniques including fractional crystallization and fractional freezing procedures. Included are zone-refining procedures which typically would increase product purity by adding recrystallization stages, but this would be done at the expense of the percentage yield of product that is formed at the last or purest recrystallization stage. For example, it is well known to use fractional crystallization in separating radium chloride from barium chloride by a classic separation procedure that utilizes a complicated grid pattern of many dozens of separate evaporation dishes or crystallizers. Under this procedure, the crystal crop of each crystallizer is transferred to the adjacent crystallizer in one direction, while the mother liquor is transferred in the opposite direction. Although increasing concentrations of radium chloride follow movement of the crystal crop from one crystallizer to the next, a very large number of crystallizers are required, and operating costs for this type of system are very high.

Generally speaking, currently available applications for fractional crystallization have recognized the desirability of operating at an optimum reflux ratio while not necessarily effectively providing suitable specifics for implementing this desirable approach.

The multistage recrystallization art includes multistep recrystallization systems for separating fluid material having two or more different components. For example, US-E-32,241 describes having a component crystallize on a cooled surface as material containing the component flows theredown. In this patent, a solution of a given stage is used to wash the crystals formed in that stage before those crystals are transferred to the next purer stage. This wash solution is the solution that is in this stage at a time immediately preceding the crystallization of any material therefrom. In an embodiment of that patent, the crystals are transferred to the next purer stage as soon as appropriate valves cause the liquid of the next purer stage to contact and dissolve the crystals. The wash solution, which is used to wash the crystal crop of a given stage, is the purest part of the solution present in that given stage before any material is crystallized from it.

Publications such as US-A-4,666,456 describe what are essentially a single stage crystallization systems. This particular patent shows continuous partial crystallization of a compound from a liquid mixture in which the mixture is fed through a cascade of a plurality of cooling sections. These cooling sections are connected in series, and the temperature of each subsequent one of the cascading cooling sections is lower than that of the preceding one.

WO-A-90/01978 relates to a multi-stage fractional freezing for super-purifying crystallizable substances, wherein processors freeze the new solution of each stage in order to form the crystals.

It has been found that, by proceeding in accordance with the present invention, it is possible to achieve superpurification of crystallizable substances by removal of certain impurities therefrom through a multistage recrystallization procedure that achieves purity levels on the order of 99.999 percent with extremely high yields that are exceptional for multistage recrystallization procedures. Included is an effective manner of controlling reflux ratio conditions while achieving and maintaining steady state operating conditions.

In summary, the present invention is a method and apparatus for superpurifying crystallizable substances by a multi-stage recrystallization procedure which includes measures to control reflux ratio conditions by providing metering procedures that control quantities of crystals and mother liquor reflux materials that are transferred according to the method and apparatus. In each stage, a crystallizable substance is dissolved within a solvent or an unsaturated solution to form a new solution and is then recrystallized from that new solution. Thereafter, the crystals are separated from the mother liquor. A controlled quantity of the mother liquor is metered, which may include transfer to a reflux receiver of that stage. In the least pure stage, this metered mother liquor provides a controlled quantity of byproduct. This metered mother liquor of the other stages is transferred to the crystals that had been separated from the crystal slurry of the next less pure stage in order to thereby wash same. Crystals collected in the purest stage provide a predetermined quantity of crystal product. A predetermined quantity of crystallizable material is fed to the least pure stage and another cycle is run. If desired, additional, similar stages may be provided in order to concentrate the byproduct in order to form a relatively large percentage of purified material and a smaller percentage of very impure material. This purified material can be used as feed material to the multistage recrystallization system.

It is a general object of the present invention to provide an improved method and apparatus for superpurifying crystallizable substances.

Another object of the present invention is to provide an improved superpurification system that utilizes multistage recrystallization that effectively, efficiently and very closely controls reflux ratio conditions.

Another object of the present invention is to provide an improvement in multistage recrystallization that can achieve and then maintain steady state conditions.

Another object of this invention is to provide improved superpurification of crystallizable substances by generally automatically metering inputs and outputs from the system and between stages of the system which maintain a gradient of differing purity levels.

Another object of this invention is to provide an improved multistage recrystallization system which achieves extremely high purification together with particularly high yields.

Another object of the present invention is to provide an improved apparatus and method for superpurification of crystallizable substances which includes the use of arrangements whereby a wash reflux from one stage of a multistage recrystallization system is used to displace residual mother liquor from crystals formed in a stage that is immediately adjacent to and that operates a lower purity levels than the stage from which the wash reflux originates.

Another object of the present invention is to provide a multistage recrystallization system wherein especially efficient and thorough separation of a minor ingredient from a major ingredient is effected.

Another object of this invention is to provide an improved apparatus and method that utilizes multiple stages and involves forming a new crystal crop in each stage from a mother liquor that is a saturated solution of the component being purified.

Another object of this invention is provide an improved multistage fractional crystallization system having a controlled reflux ratio such that the proper reflux ratio can be used to separate a minor ingredient having a given segregation coefficient.

Another object of the present invention is to provide an improved apparatus and method wherein reflux leaving a given stage of a multistage system is as impure as possible and such that the crystal material leaving that stage is as free of its mother liquor as possible in order to thereby maximize the separation efficiency of each stage.

These and other objects, features and advantages of this invention will clearly understood through a consideration of the following detailed description.

In the course of this description, reference will be made to the attached drawings, wherein:
Figure 1 is a generally schematic view or flow diagram of a multistage superpurification system according to this invention;
Figure 2 is a generally schematic view or flow diagram of an alternative embodiment for carrying out the multistage recrystallization superpurification according to the present invention; and
Figure 3 is a schematic illustration of an embodiment of a multistage impurity concentrating system useful with the invention.

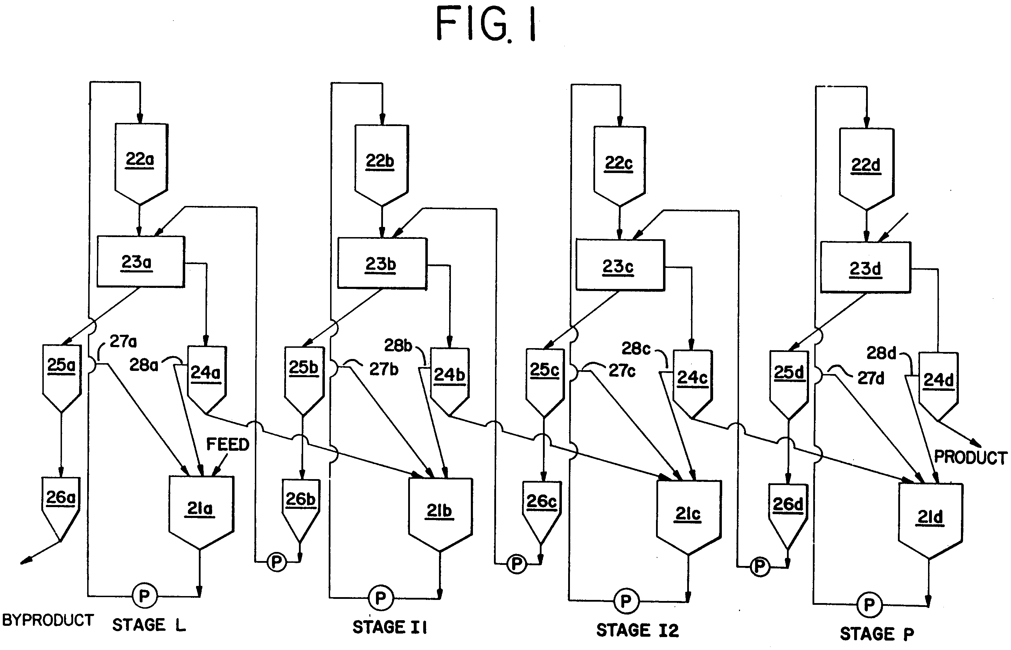

In the arrangement illustrated in Figure 1, a multistage recrystallization system is shown to include four different stages, each of which processes substantially equal quantities of various components, but with different purity levels being maintained from stage to stage. In the illustrated embodiment, Stage L is the stage at which the crystallizable material therewithin is at a purity level that is the lowest among the stages illustrated in Figure 1. Stage P is the stage at which the purity level is the highest, and Stage I1 and I2 have purities of intermediate degrees, meaning that both are purer than Stage L and less pure than Stage P, while Stage I2 is purer than Stage I1. These intermediate stages can be omitted, or additional intermediate stages can be added without significantly decreasing the yield of the multistage recrystallization system. In a typical situation, a superpurity level of on the order of 99.999 percent purity is attained with on the order of four intermediate stages. If even greater purity, or hyperpurity, is desired, six to eight or more intermediate stages could be utilized, although it must appreciated that the greater the number of intermediate stages, processing cost and time are increased. Flow rates between these various stages are substantially the same, and the flow rates are developed to ensure that there is enough solvent to dissolve the crystals within each cycle.

Each stage includes a collector 21a, 21b, 21c, 21d. This collector area or vessel can also function to dissolve, typically including heating, crystal materials within the solvent used in the system, although a separate crystal dissolver or heater assembly (not shown) can be provided as desired. The collector vessel is typically a heated vessel in which a charge of mother liquor and crystals may be heated sufficiently to dissolve the crystals to form a new solution, and in some cases this vessel may be used to evaporate a controlled weight of solvent from a batch of solution therewithin. Means such as the illustrated pump, or another suitable type of arrangement, can be used to transfer the new solution from the collector to a crystallizer 22a, 22b, 22c, 22d of each stage, wherein crystallization is effected, typically by a procedure that includes cooling. The crystallizer of each stage may be a chilled vessel to effect crystallization of appropriate portions of crystallizable material.

Downstream thereof, a separator 23a, 23b, 23c, 23d is provided in each stage for separating the crystal slurry into dewatered crystals and mother liquor. Each separator can take any suitable form, such as one utilizing gravitational separation, one that includes centrifuging procedures, and the like, as well as combinations thereof. The dewatered crystals in the separator can be transferred to a crystal receiver 24a, 24b, 24c, 24d, while the mother liquor present in the separator is transferred to a suitable mother liquor receiver 25a, 25b, 25c, 25d.

Means are then provided for metering a controlled quantity of the mother liquor from each mother liquor receiver. Such means for this location, or at other locations in the cycle, can take the form of proportioning pumps or the like (not shown) which are timed to convey a controlled volume and/or weight of each material to each stage during the proper time in the cycle. Other suitable assemblies or approaches could be used.

In the arrangement illustrated in Figure 1, this metering function is accomplished by using a metering reflux receiver 26a, 26b, 26c, 26d, which may be a vessel suitable to receive and store a measured volume or weight of mother liquor. Each reflux receiver may be used in combination with a suitable arrangement for ensuring that a preselected volume and/or weight of mother liquor is transferred thereto. One arrangement could be to provide a suitable metering device wherein the flow into the metering reflux receiver can be monitored and controlled. Another arrangement could be to provide a liquid level responsive probe within the metering reflux receiver in order to detect when a certain volume of mother liquor is present therewithin. A further approach is to provide an overflow conduit 27a, 27b, 27c, 27d wherein excess or residual mother liquor within each mother liquor receiver is removed therefrom so that the controlled quantity of mother liquor can be transferred from the mother liquor receiver 25a, 25b, 25c, 25d to the metering reflux wash receiver 26a, 26b, 26c, 26d. Whatever arrangement is utilized, it is typically preferred to incorporate an adjustability function within the metering or controlling means so that the apparatus can be used for achieving different reflux ratios and/or for processing different crystallizable materials.

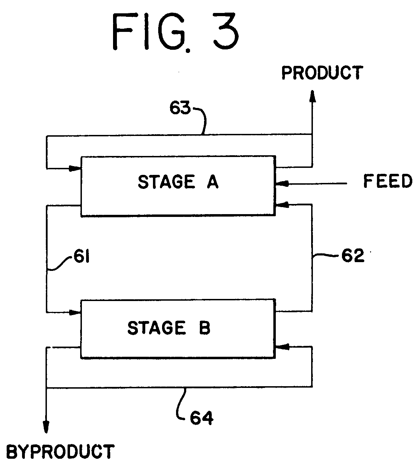

Means are further provided for transferring the thus metered or controlled volume and/or weight of mother liquor from each reflux wash receiver. In Stage L, this provides byproduct from Stage L, which byproduct can be further processed if desired in an appropriate multistage recrystallization concentration system which can be added upstream of Stage L or which can simply process the byproduct at a later time. Each stage of such a concentration system is similar to those shown in Figure 1, and are shown in more detail in Figure 3.

The other metered or otherwise controlled quantities of the mother liquor are transferred to the crystals of the next less pure stage in order to effect a washing of the crystals with a mother liquor having a purity greater than the mother liquor that remains with the crystals after operation of the separator 23a, 23b, 23c, 23d. Typically, this transfer will be in a manner such that this mother liquor will wash through the crystals, which can be readily accomplished by flowing this mother liquor into the separator. More specifically, the metered mother liquor from Stage I1 is transferred to separator 23a, the metered mother liquor from Stage I2 is transferred to separator 23b, and the metered mother liquor from Stage P is transferred to the separator 23c. Preferably, solvent of a predetermined quantity and temperature enters the separator 23d or the crystal receiver 24d in order to dissolve enough of those crystals to make up the required amount of reflux solution for Stage P and also to wash the Stage P crystal product.

Crystal material is transferred from each crystal receiver or the like to the collector or its equivalent of the next purer stage. In the case of the crystal receiver 24d, the crystals removed therefrom constitute the superpurified crystal product according to the invention. In a preferred embodiment, the quantity of this product is metered or controlled by suitable means, such as means of the type that are described hereinabove in connection with metering or controlling the mother liquor reflux operation. The drawings illustrate an excess or residual crystal transfer conduit 28a, 28b, 28c, 28d wherein any excess crystals within the crystal receiver can be transferred to the collector or the like of that same stage so that these crystals can be recrystallized and not lost and so that the reflux ratio and steady state conditions of the system are not disrupted. For example, conduit 28a transfers excess crystals from the crystal receiver 24a to the collector 21a, and substantially the same transfer can be practiced in each of the other stages of the system.

Depending upon the particular metering means utilized, transfer of the excess crystals out of the crystal receivers can take place before or after transfer of the metered amount of crystals. The transfer of the metered weight and/or volume of crystals is to the next purer stage to a location at which these crystals will next be subjected to further recrystallization and further purification. In the embodiment illustrated in Figure 1, this transfer includes metered movement of crystals from crystal receiver 24a to collector 21b, from crystal receiver 24b to collector 21c and from crystal receiver 24c to collector 21d.

Whatever materials are then present in each collector are then combined into the new solution and transferred to the crystallizer of that same stage in order to thereby effect recrystallization from the new solution of each respective collector. As for the least pure collector 21a, part of its input is the feed of recrystallizable material, which again can be metered as needed in order to maintain the reflux ratio and steady state conditions of the system. The materials then present within the collector 21a are transferred by suitable means such as the illustrated pump to the crystallizer 22a. Similarly, materials within collector 21b are transferred to crystallizer 22b, and so forth for each stage of the system.

Preferably, withdrawal of the mother liquor reflux from the crystallization vessel in which it is formed is conducted after crystallization of a given mass has been completed. This provides the greatest possible difference in purity between the crystals and the withdrawn reflux of any given stage. This maximizes the separation efficiency of each stage.

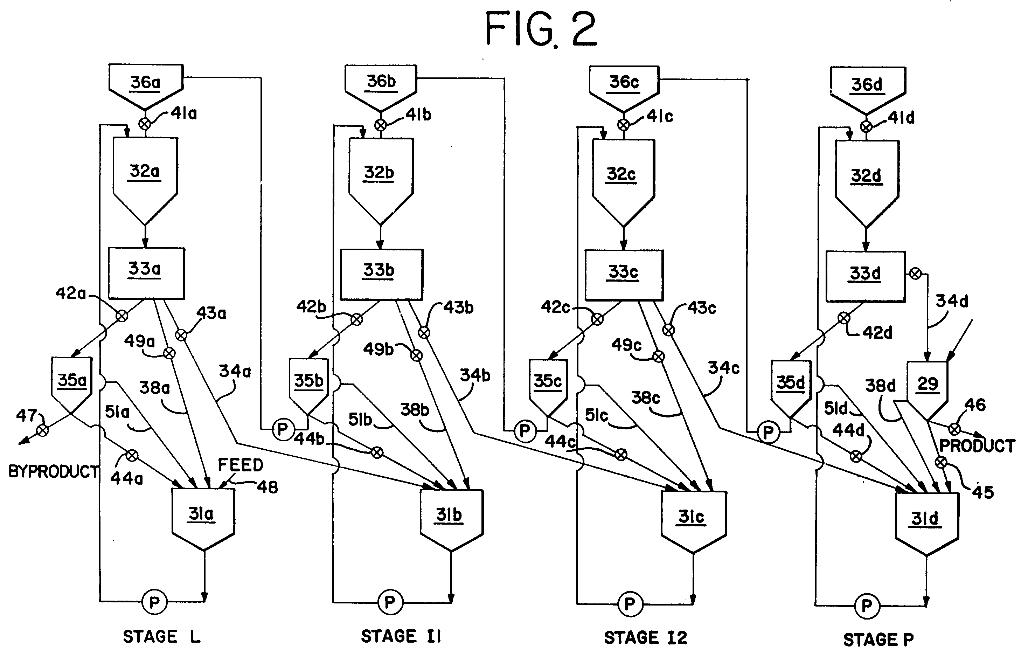

Figure 2 illustrates another embodiment of the invention that specifies other ways of realizing the objectives of the invention. Again, four stages are illustrated, Stage L, Stage I1, Stage I2 and Stage P. Each of these stages has substantially the same attributes as discussed herein with respect to the Figure 1 embodiment. Each stage includes a collector 31a, 31b, 31c, 31d, a crystallizer 32a, 32b, 32c, 32d, and a separator 33a, 33b, 33c, 33d, each of which operate in much the same manner as the similarly designated components of the Figure 1 embodiment.

Rather than providing a separate crystal receiver of the type illustrated in Figure 1, the needed quantity of crystals are transferred from the separator of one stage to the collector of the next purer stage through a conduit 34a, 34b, 34c. Such crystal flow can be facilitated by a pump and/or metering device as generally discussed herein and as generally illustrated in Figure 2. Transfer of these crystals from separator 33a passes to collector 31b, while crystals from separator 33b pass to collector 31c, and crystals from collector 33c pass to collector 31d. In the illustrated embodiment, one crystal receiver 29 is included. Desired product is transferred therefrom through conduit 46.

Excess crystal material from each stage, preferably together with wash material as discussed hereinafter, passes to the collector of that same stage for subsequent recrystallization within the crystallizer of that stage. In Stage L, Stage I1 and Stage I2, this transfer is effected directly from separator 33a, 33b, 33c through conduit 38a, 38b, 38c, and to the collector 31a, 31b, 31c, respectively, of that stage. In Stage P, this transfer is illustrated as being from the crystal receiver 29, through conduit 38d and to collector 31d.

Material within each collector 31a, 31b, 31c, 31d is transferred to the respective crystallizer for each stage, as illustrated. In this embodiment, mother liquor from the mother liquor receiver 35a is transferred as byproduct, whereas mother liquor from receivers 35b, 35c, 35d is transferred to a reflux wash receiver 36a, 36b, 36c. Substantially pure solvent can be introduced into the reflux wash receiver 36d, if desired. Metering means such as valves, pumps and the like can be positioned at 49a, 49b, 49c to permit drainage of reflux wash from the crystals, which are washed within the separator 33a, 33b, 33c, 33d.

With more particular reference to the operation of the Figure 2 embodiment, valves 41a, 41b, 41c, 41d or the like can be provided to control the rate of drainage of reflux wash from the reflux wash receiver of each stage and into the crystallizer of that stage. Valves 42a, 42b, 42c, 42d or the like are provided to control the drainage of mother liquor from the separator of each stage to its mother liquor receiver. As generally previously discussed, valves 43a, 43b, 43c or other suitable metering means are provided to permit control of transfer of crystals from the separator of each stage to the collector of the next purer stage or, in the case of metering means 34d, to the crystal receiver 29. Valve or other metering means 44a, 44b, 44c, 44d, can be provided to control drainage of mother liquor from the mother liquor receiver to the collector of that same stage. Means 45 controls transfer of excess crystal material to the collector of the purest stage, and means 46 controls transfer of product out of the multistage system illustrated in Figure 2. Metering means 47 can be provided for controlling the flow of byproduct out of the system, in this case from the mother liquor receiver 35a. Feed into the system can be through transfer means 48, which opens into the collector 31a in the least pure stage.

Means such as overflow conduits 51a, 51b, 51c, 51d are provided to permit transfer of excess or overflow mother liquor from the mother liquor receiver of each stage and into the collector of that same stage. Overflow conduit 38d can be used to transfer overflow crystals from the crystal receiver 29 to the collector 31d of the purest stage. These overflow means can function to determine the volume of holdup to be retained in the mother liquor receiver or crystal receiver by virtue of its level within such receiver.

With reference to Figure 3, an impurity concentration system having two stages is illustrated. Again, additional stages can be added as desired. Details of the components of each stage are generally in accordance with that shown in Figure 1, Figure 2, or equivalents thereof. Generally speaking, the impurity concentrating section can be provided for the purpose of concentrating the impurities in the byproduct from Stage L into a small portion of very impure new byproduct and a larger portion of purified material which is suitable for providing some of the feed to Stage L. This typically improves the yield of the total system, particularly where the product from the impurity concentrating section is returned to Stage L as feed material. This can be facilitated by having the product from the impurity concentrating section be of a purity substantially the same as the crystallizable material feed to Stage L. Generally speaking, the byproduct of the impurity concentrating section would constitute a small volume percentage of the feed thereto and would have a much higher concentration of impurities than its feed material, which is the byproduct from Stage L.

One difference between the operation of the impurity concentration system and a primary system of the type illustrated in Figures 1 and 2 is that the feed into the impurity concentrating system is to its stage that operates at its higher or highest purity, which is Stage A as illustrated in Figure 3.

Stage B, the stage that operates with the lesser or least purity of materials, communicates with Stage A in substantially the same manner as adjacent stages in Figure 1, Figure 2 or the like. Mother liquor is transferred from purer Stage A to less pure Stage B through transfer means 61. Crystal material from Stage B moves to Stage A through transfer means 62. A desired quantity of product exits Stage A, while recycle crystal material re-enters Stage A via transfer means 63. A desired quantity of byproduct is removed from Stage B, while mother liquor recycle is carried out by way of a transfer means 64.

With more particular reference to the various controlling and/or metering functions and means that are discussed in conjunction with the various stages and transfers between them, the following controlling and/or metering aspects are preferred. During each cycle, substantially the same volume of reflux mother liquor should be transferred from each stage to the next lower numbered stage. During each cycle, substantially the same volume of recrystallized crystal material should be transferred from each stage to the next higher numbered stage. During each cycle, a controlled volume of recrystallized crystal material should be discharged from the purest stage as product of the refining system. During each cycle, a controlled volume of mother liquor should be discharged from the least pure stage as byproduct from the refining system. During each cycle, a volume of feed material that is substantially the same as the sum of the volumes of the product and byproduct passed out of the system should be introduced into the least pure stage of the primary system and/or into the purer or purest stage of the impurity concentrating system.

During each cycle, a sufficient amount of material, and typically an amount somewhat in excess thereof, must be recrystallized in order to provide at least enough crystal material to enable the proper volume of this material to be transferred from every stage to the next purer stage during each operating cycle. During each cycle, conditions within the crystallizer, including crystallization time, should be limited or otherwise controlled such that a sufficient volume of mother liquor remains in each crystallizer to enable the proper volume of mother liquor reflux to be transferred from each stage to the next lower numbered stage during each operating cycle.

The reflux ratio of a given section is the ratio of the weight per cycle of reflux solute (which is discharged from each stage of the system, monitored for example at the purest stage) to the weight per cycle of crystal product discharged from this same stage. The reflux ratio of the impurity concentrating system can be different from that of the primary recrystallization system, and the duration of each cycle for each of these systems may also be different. The reflux ratio can be controlled by regulating the volume of product removed from the system per cycle and the volume of reflux transferred from stage to stage. The percentage yield of superpure product that is recovered from the crystallizable material fed to the system is controlled by regulating the volume per cycle of product and of byproduct removed from the refining system. Generally speaking, the higher the reflux ratio (e.g. 1:1), the greater is the difference in purity per stage from one stage to the next purer stage, and the lower the reflux ratio (e.g. 0.5:1). the greater amount of product is produced each cycle.

With more particular reference to controlling the reflux ratio, this may be accomplished by controlling the weight of reflux solute that is transferred per unit of time from each stage to the next less pure stage, and by controlling the weight of crystal product from each stage which is transferred per unit of time from each stage to the next purer stage. In addition, the weight of crystal product which is produced per unit time can be indirectly controlled by controlling the weight per unit of time of crystals entering the purest stage and of reflux solute leaving that stage per unit time, with the difference between these entering crystals and the leaving reflux solute being the weight of crystal product. More specifically, two major factors which determine the reflux ratio of a system are controlled. These factors are the net weight of crystal product produced per cycle by the purest stage and the weight of mother liquor reflux solute transferred per cycle from this same stage to the next less pure stage.

By the indirect metering approach, the operator may meter the correct weight of reflux solute by withdrawing the proper volume of mother liquor to be used as reflux. The percentage of solute in the reflux is a function of its specific gravity, and monitoring same may be useful in providing the proper volume of reflux needed in order to result in having the correct weight of solute transferred as reflux. It may also be desirable and preferred to monitor and control the specific gravity of new solution made up during each stage when all of the crystals that have been added to that stage's crystal dissolver and the mother liquor therein are combined to make up such a new solution. The specific gravity can be adjusted as needed by either adding pure solvent to, or by evaporating solvent from the new solution. Specific gravity adjustments may be made in any stage's crystal dissolver by either the addition of pure solvent thereto or the evaporation of solvent therefrom.

Maintenance of a desirable steady state condition throughout the system is important. When this steady state condition is achieved, the system exhibits the following characteristics. The same weight of crystallizable material to be purified (or the major ingredient) is present in the crystallizer of each stage while crystallization is occurring. The same weight is present in the crystallizer of each stage during the crystallization period of each cycle. Each stage produces the same weight of crystal product during each cycle, which weight would be substantially the same as that of the feed introduced to the system. The same weight of product crystals are produced during each cycle. The same weight of byproduct solute is produced during each cycle. The weight of product per cycle is substantially the same as the weight of feed introduced per cycle minus the weight of byproduct solute produced per cycle. Each cycle has substantially the same reflux ratio.

Such steady state conditions are achieved and maintained according to the present invention by the following steps. Add the same weight of feed during each cycle of this system. Add the same weight of pure solvent to the purest stage during each cycle of the system, which weight should be just sufficient to produce the required amount of reflux that must be discharged from this stage during each cycle. Monitor and adjust the specific gravity of the new solution in the crystal dissolver or collector so that the specific gravity of each solution to be crystallized is the same in each stage. Monitor and adjust the temperature of the solution to be crystallized and separated to insure that the crystallization temperature and the specific gravity of the mother liquor of each stage is the same during each cycle. All of the crystal product that is recrystallized in each stage is transferred to the crystal dissolver of the next purer stage during each cycle. The same volume of mother liquor reflux from each stage is transferred to the next less pure stage (or transferred as byproduct from the least pure stage). During each cycle, the crystal product is removed from the purest stage after pure solvent has been added to that stage to make up the new reflux for it.

When these conditions are maintained, the weight of crystals produced in each stage will be the same per cycle as the weight of feed introduced to the least pure stage during each cycle. Also, when steady state conditions such as these are maintained, the reflux ratio of the system will remain substantially the same during a series of cycles in a run.

A sufficient quantity of mother liquor holdup should be maintained in each stage in order to permit the production of an adequate weight of crystals per cycle in each stage. This needed weight is at least equal to or greater than the weight of feed introduced during each cycle.

When controlling the reflux ratio according to the present invention, it is necessary to control both the weight of product per cycle as well as the amount of reflux transferred. Regarding regulating the weight of crystal product, three controllable variables can be considered. These are: feed introduced during each cycle, byproduct discharged each cycle, and crystal product discharged each cycle. By introducing the same weight and/or volume of material to each stage's crystallizers at the start of the crystallization period, control of any two of these variables will automatically regulate the third one. In all situations, the weight and/or volume of feed introduced per cycle is substantially equal to the sum of the weights and/or volumes of the product and byproduct discharged per cycle. In addition, the reflux transfer can be maintained by metering the mother liquor reflux that is transferred from each stage to the next less pure stage or by metering the recrystallized crystal material that is transferred from each stage to the next purer stage.

Accordingly, control of reflux ratio conditions can be accomplished according to the present invention by metering three different transfers. In a first case, the crystallizable material feed, the mother liquor byproduct and the mother liquor reflux are each metered. In a second case, the recrystallized product, the feed, and the reflux are metered. In a third case, the product, the byproduct and the reflux are metered. In a fourth case, the feed, the byproduct and the crystal material that is transferred from one stage to another are metered. In a fifth case, the product, the feed and the crystal material transfer are metered. In the sixth case, the product, the byproduct and the crystal material transfer are each metered.

The procedure and apparatus according to the present invention are suitable for superpurification of various crystallizable salts within solvents therefor, such as water, alcohols, ethers, ketones, and the like. Exemplary recrystallizable materials in this regard include sodium chloride, potassium chloride, cesium chloride, barium nitrate, copper nitrate, sodium iodide, barium chloride, copper sulfate, nickel sulfate, alum (ammonium aluminum sulfate), ammonium molybdate, and the like. The following examples illustrate some specific procedures suitable for these types of materials.

### Example 1

An impurity stripping system of the type generally illustrated in Figure 1 but including six stages, rather than the four stages illustrated in that drawing was run for the production of 8.46 kilograms per cycle of superpure cesium chloride crystals and 4.23 kilograms of impure cesium chloride solute byproduct from 12.7 kilograms per cycle of technical grade cesium chloride crystal feed material. The solvent utilized was water. The operator of this system could maintain or change the reflux ratio, depending upon the particular objectives of each cycle.

First, initial calibration or startup cycles were run. Before the start of the first cycle of the calibration operation, 35.86 kilograms of technical grade cesium chloride feed and 13.26 liters of distilled water were added to the collector of each stage. The system was then run for twelve cycles at a reflux ratio of 1 to 0 in order to achieve a normal operating distribution of impurities in the system before normal operation is begun. Thereafter, the reflux ratio was changed to 1 to 0.5 for each cycle.

During the startup of 1 to 0 reflux ratio cycles, the crystal dissolver containers or collectors were heated to boiling, approximately 118°C., until all crystals were dissolved. In those stages where the specific gravity needed adjustment, either distilled water was added to lower the specific gravity, or additional evaporation was carried out to increase the specific gravity so that the crystallization temperature of the solution in each stage was as close as possible to 100° C. Crystallization was then carried out over a two hour period during which the temperature was lowered to 10° C., and very close to 12.7 kilograms of cesium chloride crystals were formed in each stage. After separation of these crystals from the mother liquor, 19.97 kilograms of mother liquor were transferred from each stage's mother liquor receiver to that same stage's metering reflux receiver. This transferred mother liquor contained 12.7 kilograms of cesium chloride solute for each stage.

The separated crystals were then washed while being spun in a centrifuge of the separator of each stage, the washing being with the reflux mother liquor from the reflux receiver of the next purer stage. In addition to washing the crystals, this step also transferred the reflux from each stage to the next less pure stage. Since there was no reflux which entered the highest numbered stage, the crystals of that stage were not washed. The result of this washing step is that the composition of any mother liquor which still wets the crystals of any given stage after the washing step had substantially the same composition as the mother liquor of the next purer stage to which those crystals were subsequently transferred.

Transfer of crystals was next effected, with 12.7 kilograms of washed crystals transferred to the crystal dissolving container or collector of the next purer stage, except in the case of the purest stage. Because these early cycles were of a startup or calibration nature and at a 1 to 0 reflux ratio, the recrystallized crystals of the purest stage were transferred to the crystal dissolver or collector of that same stage, and 7.27 kilograms of water were added thereto to enable all of the crystals to dissolve.

The mother liquor holdup in the mother liquor receiver of each stage was returned to the collector of each stage, and water was evaporated from the least pure crystal dissolver or collector until the specific gravity of the solution increased to a point that it achieved a crystallization temperature of 100° C.

This procedure was run through twelve consecutive cycles. For all cycles thereafter, the reflux ratio was modified to what had been determined to be an advantageous reflux ratio of 1 to 0.5. 12.7 kilograms of cesium chloride feed to be superpurified was introduced into the crystal dissolver or collector of the least pure stage, 8.46 kilograms of superpure product having a purity of 99.999 percent were transferred from the purest stage during each cycle, and 4.23 kilograms of byproduct solute were withdrawn from the least pure stage during each cycle.

The procedure followed for each cycle was as carried out during the calibration cycles, with the following modifications. 6.65 kilograms of mother liquor were withdrawn from the mother liquor receiver and transferred to the metering reflux receiver of each stage. This known quantity of mother liquor reflux had a crystallization temperature of 10^{o} C. and contained 4.23 kilograms of cesium chloride solute and 2.42 kilograms of water solvent. The contents of the reflux receiver of the least pure stage were discharged as byproduct. For the other stages, the 6.65 kilograms of reflux were transferred to wash the recrystallized crystals of the next less pure stage. The recrystallized crystals of the purest stage were washed with 2.42 kilograms of warm distilled water, and these crystals were removed from the system as 8.46 kilograms of product. The recrystallized crystals of the other stages were transferred to the crystal dissolver or collector of the next purer stage. There was no need to boil down the least pure stage. Instead, another 12.7 kilograms of cesium chloride feed material were added.

During these non-calibration or operational cycles, steady state conditions were established and maintained in each of the stages. These steady state conditions include having the same holdup weight of cesium chloride, 35.56 kilograms, in each crystal dissolver or collector at the end of each cycle of each run. The same weight, 12.7 kilograms, of cesium chloride crystals were formed in each stage's crystallizer during each cycle of each run. The same weight, 8.46 kilograms, of cesium chloride product were produced during each cycle.

The reflux ratio was controlled at 1 to 0.5 during each cycle of the run, such having been made possible by the establishment of these steady state conditions and by direct regulation of the weight of feed introduced per cycle and the rate of reflux transferred from stage to stage in the system. This regulation, in turn, controlled the weight of product that was produced per cycle.

### Example 2

An impurity concentrating system of the type generally illustrated in Figure 3 was run, except it was of the 3-stage variety. This system was used to process the cesium chloride byproduct solution produced according to Example 1. This impurity concentrating system recovered 75 percent of the solute as a crystal product having substantially the same purity as the feed material into the Example 1 system. The remaining 25 percent of this feed solute was converted to a very impure solute that contained substantially all of the impurities that were in the feed material. The byproduct solution from Example 1 that was the feed into this impurity concentrating system had a crystallization temperature of 10° C. and contained approximately 63.6 weight percent of cesium chloride solute. A typical solute in this regard also contained about 500 ppm sodium chloride and about 5,000 ppm rubidium chloride by weight.

The crystal dissolver of each stage of the impurity concentrating system was filled with 33.3 kilograms of the feed and thus 21.19 kilograms cesium chloride solute and 12.12 kilograms water. Adjustment of the specific gravity to indicate a crystallization temperature of 100° C. required evaporation of the water to 7.83 kilograms.

Crystallization produced 7.5 kilograms of cesium chloride crystals for each stage, and the mother liquor and crystals were separated as described in Example 1. 7.47 kilograms of mother liquor were transferred from the purest stage mother liquor receiver to its reflux receiver, and 4.37 kilograms of the least pure mother liquor were transferred to its reflux receiver. Crystal washing took place, and 7.5 kilograms of washed crystals in the purest stage were removed as product of the impurity concentrating section. 7.5 kilograms of washed crystals from the least pure stage were transferred to the next purer stage.

Boildown was effected in the least pure crystal dissolver, same containing 33.3 kilograms of solution that had 21.17 kilograms of cesium chloride solute and 12.12 kilograms of water which were reduced to 7.83 kilograms of water. After boildown, 29 kilograms of new solution having a crystallization temperature of approximately 100° C. were present. Crystal dissolving within the purer stages provided 33.3 kilograms of new solution which included 21.17 kilograms of cesium chloride solute and 12.12 kilograms of water.

Additional cycles which were identical to this first one were conducted to continue the production of 7.5 kilograms of crystal product per cycle and 2.5 kilograms of impure cesium chloride solute per cycle. After several cycles, the impurity distribution in the stages of this impurity concentration section reached an equilibrium condition. When equilibrium was reached, the byproduct solute contained almost four times the concentration of impurities as the feed solute. The reflux ratio of the impurity concentrating section was 1 to 0.75.

## Claims

1. A method for superpurifying crystallizable substances by a multistage recrystallization procedure which includes controlling reflux ratio conditions, comprising:
providing a plurality of stages having vessels with crystallizable substances therein and operating said stages by proceeding with a sequence of steps in a cyclic manner through a plurality of substantially duplicate cycles conducted substantially simultaneously during each stage such that the crystallizable substance in each stage is dissolved and recrystallized within each such stage, one of said stages being a least pure stage during which a controlled quantity of crystallizable substance to be superpurified is added from outside of the plurality of stages as feed to a vessel of the least pure stage, another of said stages being a purest stage during which solvent which does not contain and is different from said crystallizable substance is added to said purest stage from outside of the plurality of stages, the sequence of steps comprising:
(a) dissolving within a collector vessel (21) crystallizable substance to be recrystallized, said crystallizable substance for the least pure stage (L) being said feed of crystallizable substance to be superpurified, and said crystallizable substance for the remaining stage or stages having been recrystallized in a next less pure stage, whereby this crystallizable substance and mother liquor from the stage being subjected to the dissolving step are combined in said stage, the mother liquor being composed principally of said solvent, to thereby dissolve the crystallizable substance within the solvent and form a saturated separate new solution within the collector vessel, said saturated separate new solution being one in which all of the crystallizable substance is dissolved in said solvent;
(b) transferring said saturated separate new solution of each stage from the collector vessel (21) to a crystallizer vessel (22);
(c) recrystallizing said crystallizable substance in the crystallization vessel (22) of each stage, said recrystallizing step including lowering the temperature of said saturated separate new solution to a selected temperature at which the crystallizable substance thereof recrystallizes without freezing in order to thereby form a quantity of crystal slurry in each said stage, said crystal slurry including thus recrystallized crystals;
(d) transferring said crystal slurry to a separator vessel (23) of that stage;
(e) separating within the separator vessel (23) said crystal slurry into separated recrystallized crystals and separated mother liquor;
(f) transferring a controlled quantity of said separated mother liquor separated in step (e) to a reflux vessel (25, 26) of that stage, and transferring any remainder of said separated mother liquor to the collector vessel (21) of that stage, whereby substantially only said separated recrystallized crystals remain in the separator vessel (23);
(g) when said stage is said least pure stage (L), said controlled quantity of separated mother liquor of step (f) is a byproduct transferred out of the plurality of stages;
(h) when said stage (P, I2, I1) is a stage other than said least pure stage (L), the controlled quantity of mother liquor provided to the reflux vessel (26) in step (f) is transferred to the separator vessel (23) of the next less pure stage (I2, I1, L) whereby said separated recrystallized crystals in said separator vessel (23) are washed with mother liquor purer than the mother liquor of said next less pure stage;
(i) transferring a controlled quantity of said recrystallized crystals separated in step (e) to the collector vessel (21) of the next purer stage, which recrystallized crystals are the crystallizable substance of step (a) except that said step (i) transferring step of the purest stage transfers the controlled quantity of recrystallized crystals out of the plurality of stages as a superpurified recrystallized crystal product, and transferring any remainder of said recrystallized crystals separated in step (e) to the collector vessel (21) of that stage; and
(j) controlling the reflux ratio of the multistage recrystallization procedure by metering (26) the controlled quantity of mother liquor that is transferred during step (f) and by controlling the recrystallized crystal product transferred from the purest stage (P) during step (i).

2. The method according to Claim 1, wherein said crystal product has a purity of 99.999 percent.

3. The method according to Claim 1 or 2, wherein temperature conditions are substantially the same within each said stage.

4. The method according to Claim 1, 2, or 3, wherein the system includes between two and about ten stages.

5. The method according to any one of Claims 1 to 4, wherein each controlled quantity of mother liquor and crystals that moves between stages is substantially the same irrespective of the stage from which or to which movement is effected.

6. The method according to any one of Claims 1 to 5, further including transferring the crystals separated in step (e) to a crystal receiver (24) for carrying out step (i).

7. The method according to any one of Claims 1 to 6, further including adjusting the specific gravity of new solution in each collector prior to step (c).

8. The method according to any one of Claims 1 to 7, wherein said step of controlling reflux ratio includes adding, removing and/or transferring the same quantities of crystallizable material feed crystals, mother liquor, byproduct, wash, and product in each stage of the system and throughout each cycle thereof, and maintaining the same temperature conditions in each stage and each cycle.

9. The method according to any one of Claims 1 to 8, wherein said controlling of the product discharged from the system includes controlling any two of crystallizable material feed introduced each cycle, byproduct discharged each cycle and product discharged each cycle.

10. The method according to any one of Claims 1 to 9, wherein said step (j) metering of said controlled quantity of mother liquor is indirectly controlled by metering recrystallizable crystal material that is transferred from each stage to the next purer stage.

11. The method according to any one of Claims 1 to 10, wherein said controlling of the product discharged from the system includes controlling any two of crystallizable material feed introduced each cycle, byproduct discharged each cycle and product discharged each cycle, and wherein said step (j) metering of said controlled quantity of mother liquor is indirectly controlled by metering recrystallizable crystal material that is transferred from each stage to the next purer stage.

12. The method according to any one of Claims 1 to 11, further including an impurity concentrating system having a plurality of concentration stages for further processing said step (g) byproduct, said impurity concentrating system including a purest concentration stage and a least pure concentration stage; wherein feed into the impurity concentrating system is into said purest concentration stage, byproduct out of the impurity concentrating system is from said least pure concentration stage, and concentration product out of the impurity concentrating system is from said purest concentration stage, said concentration product being purer than said step (g) byproduct; and wherein each said concentration stage dissolves the crystallizable substance, recrystallizes same, separates into crystals and mother liquor, transfers a controlled quantity of mother liquor to a stage of next lesser purity, and transfers crystals to a stage of next greater purity.

13. The method according to any one of Claims 1 to 12, wherein said step of transferring a controlled quantity of mother liquor includes moving mother liquor to a reflux receiver upstream of the crystallizer (32) of each such stage prior to said step which provides a controlled quantity of mother liquor that washes the crystals of the next less pure stage.

14. An apparatus for superpurifying crystallizable substances by a cyclic multistage recrystallization procedure, comprising:
a) a plurality of stages (L, I1, I2, P) having components including collector vessels (21) for each stage, said stages proceeding through substantially duplicate cycles conducted substantially simultaneously within each stage and including a least pure stage (L) and a purest stage (P);
b) means for adding a controlled quantity of crystallizable substance to the collector means of the least pure stage (L);
c) means for adding a solvent for a crystallizable substance to said purest stage (P), said solvent being different from and does not contain the crystallizable substance;
d) means for dissolving crystallizable substance within mother liquor including said solvent therefor to form a saturated new solution within each collector vessel (21);
e) crystallization vessel (22) for recrystallizing substantially all of the crystallizable substance in each saturated new solution by lowering the temperature of each said saturated new solution of each stage to a selected temperature without freezing and at which the crystallizable substance crystallizes from the new solution in order to form a quantity of crystal slurry in each said stage, said crystal slurry including thus recrystallized crystals;
f) separator vessel (23) for separating said crystal slurry of each of said stages into recrystallized crystals and mother liquor and for transferring the separated mother liquor to a mother liquor receiver of each said stage;
g) reflux vessel (25, 26) of each said stage, said reflux vessel being downstream of and being for metering a controlled quantity of mother liquor from the mother liquor receiver of its stage to thereby provide a controlled quantity of mother liquor;
h) means for transferring said controlled quantity of mother liquor of each stage except for said least pure stage (L) to the next less pure stage and for washing said recrystallized crystals of that next less pure stage with mother liquor from a purer stage;
i) means for transferring said controlled quantity of mother liquor from the least pure stage and for thus providing a controlled quantity of byproduct;
j) means for moving a controlled quantity of the recrystallized crystals from said separator vessel (23), except for those of the purest stage (P), to said collector vessel (21) of the next purer stage;
k) means for collecting a controlled quantity of the recrystallized crystals from said separator vessel (23) of the purest stage (P) as a controlled quantity of superpurified crystal product;
l) means for passing residual mother liquor from said mother liquor receiver of each stage to the collector of that same stage, the residual mother liquor being mother liquor in excess of that controlled quantity of mother liquor metered by said reflux means;
m) means for controlling the reflux ratio of the multistage apparatus, said controlling means including said reflux means and said means for collecting the controlled quantity of superpurified product, said controlling means further including means for maintaining steady state conditions within and between each stage of said system.

15. The apparatus according to Claim 14, wherein each said means for transferring said controlled quantity of mother liquor to the next less pure stage is a means for wash transferring a controlled quantity of mother liquor passed to the mother liquor receiver (25, 26, 35) of stages other than said least pure stage the separating means of the next less pure stage.

16. The apparatus according to Claim 14 or 15, further including means for maintaining substantially equal temperature conditions within each respective component of each said stage.

17. The apparatus according to Claim 14, 15, or 16, wherein the apparatus includes between two and about ten of said stages.

18. The apparatus according to any one of Claims 14 to 17, wherein said crystals moving means includes a crystal receiver vessel separate from said separating means.

19. The apparatus according to any one of Claims 14 to 18, further including means for adjusting the specific gravity of the new solution slurry within each collector means.

20. The apparatus according to any one of Claims 14 to 19, wherein said steady state condition maintaining means includes means for controlling said transferring means, said wash transferring means, said moving means and said collecting means, whereby each said means controls movement of substantially equal quantities of respective materials between each of said plurality of stages.

21. The apparatus according to any one of Claims 14 to 20, further including an impurity concentrating system having a plurality of concentration stages for further processing the byproduct from said least pure stage, said impurity concentrating system includes a purest concentration stage and a least pure concentration stage, feed input means for passing the byproduct of said least pure stage into said purest concentration stage, output means for removing byproduct from said least pure concentration stage, and product outflow means for removing concentration product from said purest concentration stage, said concentration product being purer than said byproduct from said least pure stage; and
wherein each of said concentration stages includes means for dissolving the byproduct of the least pure stage, means for recrystallizing same, means for separating same into crystals and mother liquor, means for transferring a controlled quantity of mother liquor to a stage of next lesser purity, and means for transferring crystals to a stage of next greater purity.

22. The apparatus according to any one of Claims 14 to 21, wherein said transferring means includes a reflux receiver vessel (26, 36) separate from said mother liquor receiver (25, 35).

## Patentansprüche

1. Verfahren zum Hochreinigen kristallisierbarer Stoffe durch einen mehrstufigen Rekristallisationsablauf, der ein Steuern von Rückflußverhältnisbedingungen aufweist, mit:
Bereitstellen mehrerer Stufen, die Behälter mit kristallisierbaren Stoffen darin haben, und Betreiben der Stufen durch Abarbeiten einer Folge von Schritten auf zyklische Weise über mehrere im wesentlichen duplizierte Zyklen, die im wesentlichen gleichzeitig während jeder Stufe so durchgeführt werden, daß der kristallisierbare Stoff in jeder Stufe gelöst und innerhalb jeder solchen Stufe rekristallisiert wird, wobei eine der Stufen eine unreinste Stufe ist, während der eine gesteuerte Menge von hochzureinigendem kristallisierbaren Stoff von außerhalb der mehreren Stufen als Beschickung einem Behälter der unreinsten Stufe zugegeben wird, eine weitere der Stufen eine reinste Stufe ist, während der Lösungsmittel, das den kristallisierbaren Stoff nicht enthält und sich von ihm unterscheidet, zu der reinsten Stufe von außerhalb der mehreren Stufen zugegeben wird, und die Folge von Schritten aufweist:
(a) in einem Sammelbehälter (21) erfolgendes Lösen von kristallisierbarem Stoff, der zu rekristallisieren ist, wobei der kristallisierbare Stoff für die unreinste Stufe (L) die Beschickung von hochzureinigendem kristallisierbaren Stoff ist und der kristallisierbare Stoff für die restliche(n) Stufe(n) in einer nächstunreineren Stufe rekristallisiert wurde, wodurch dieser kristallisierbare Stoff und Mutterlauge von der dem Löseschritt unterzogenen Stufe in der Stufe kombiniert werden, wobei sich die Mutterlauge hauptsächlich aus dem Lösungsmittel zusammensetzt, um dadurch den kristallisierbaren Stoff in dem Lösungsmittel zu lösen und eine gesättigte separate neue Lösung innerhalb des Sammelbehälters zu bilden, wobei die gesättigte separate neue Lösung eine ist, in der der kristallisierbare Stoff insgesamt in dem Lösungsmittel gelöst ist;
(b) Überführen der gesättigten separaten neuen Lösung jeder Stufe von dem Sammelbehälter (21) zu einem Kristallisierbehälter (22);
(c) Rekristallisieren des kristallisierbaren Stoffs in dem Kristallisationsbehälter (22) jeder Stufe, wobei der Rekristallisierschritt aufweist: Senken der Temperatur der gesättigten separaten neuen Lösung auf eine ausgewählte Temperatur, bei der ihr kristallisierbarer Stoff ohne Gefrieren rekristallisiert, um dadurch eine Menge von Kristallschlamm in jeder Stufe zu bilden, wobei der Kristallschlamm derart rekristallisierte Kristalle aufweist;
(d) Überführen des Kristallschlamms zu einem Trennbehälter (23) dieser Stufe;
(e) innerhalb des Trennbehälters (23) erfolgendes Trennen des Kristallschlamms in abgetrennte rekristallisierte Kristalle und abgetrennte Mutterlauge;
(f) Überführen einer gesteuerten Menge der abgetrennten Mutterlauge, die in Schritt (e) abgetrennt wird, zu einem Rückflußbehälter (25, 26) dieser Stufe und Überführen eines Rests der abgetrennten Mutterlauge zu dem Sammelbehälter (21) dieser Stufe, wodurch im wesentlichen nur die abgetrennten rekristallisierten Kristalle in dem Trennbehälter (23) verbleiben;
(g) ist die Stufe die unreinste Stufe (L), so ist die gesteuerte Menge von abgetrennter Mutterlauge von Schritt (f) ein Nebenprodukt, das aus den mehreren Stufen herausgeführt wird;
(h) ist die Stufe (P, I2, I1) eine andere Stufe als die unreinste Stufe (L), so wird die gesteuerte Menge von Mutterlauge, die zu dem Rückflußbehälter (26) in Schritt (f) geführt wird, zu dem Trennbehälter (23) der nächstunreineren Stufe (I2, I1, L) überführt, wodurch die abgetrennten rekristallisierten Kristalle in dem Trennbehälter (23) mit Mutterlauge gewaschen werden, die reiner als die Mutterlauge der nächstunreineren Stufe ist;
(i) Überführen einer gesteuerten Menge der in Schritt (e) abgetrennten rekristallisierten Kristalle zu dem Sammelbehälter (21) der nächstreineren Stufe, wobei die rekristallisierten Kristalle der kristallisierbare Stoff von Schritt (a) mit der Ausnahme sind, daß der Überführungsschritt der reinsten Stufe in Schritt (i) die gesteuerte Menge von rekristallisierten Kristallen aus den mehreren Stufen als hochgereinigtes rekristallisiertes Kristallprodukt herausführt, und Überführen eines Rests der in Schritt (e) abgetrennten rekristallisierten Kristalle zu dem Sammelbehälter (21) dieser Stufe; und
(j) Steuern des Rückflußverhältnisses des mehrstufigen Rekristallisationsablaufs durch Dosieren (26) der gesteuerten Menge von Mutterlauge, die während des Schritts (f) überführt wird, und durch Steuern des rekristallisierten Kristallprodukts, das von der reinsten Stufe (P) während des Schritts (i) überführt wird.

2. Verfahren nach Anspruch 1, wobei das Kristallprodukt eine Reinheit von 99,999 Prozent hat.

3. Verfahren nach Anspruch 1 oder 2, wobei Temperaturbedingungen innerhalb jeder Stufe im wesentlichen gleich sind.

4. Verfahren nach Anspruch 1, 2 oder 3, wobei das System zwischen zwei und etwa zehn Stufen aufweist.

5. Verfahren nach einem der Ansprüche 1 bis 4, wobei jede gesteuerte Menge von Mutterlauge und Kristallen, die sich zwischen Stufen bewegt, ungeachtet der Stufe, von oder zu der eine Bewegung erfolgt, im wesentliche gleich ist.

6. Verfahren nach einem der Ansprüche 1 bis 5, ferner mit Überführen der in Schritt (e) abgetrennten Kristalle zu einem Kristallauffänger (24) zum Durchführen von Schritt (i).

7. Verfahren nach einem der Ansprüche 1 bis 6, ferner mit Einstellen der relativen Dichte einer neuen Lösung in jedem Sammler vor Schritt (c).

8. Verfahren nach einem der Ansprüche 1 bis 7, wobei der Schritt des Steuerns des Rückflußverhältnisses aufweist: Zugeben, Entfernen und/oder Überführen der gleichen Mengen von kristallisierbaren Materialbeschickungskristallen, Mutterlauge, Nebenprodukt, Waschflüssigkeit und Produkt in jeder Stufe des Systems und durchgängig während jedes Zyklus davon sowie Aufrechterhalten der gleichen Temperaturbedingungen in jeder Stufe und jedem Zyklus.

9. Verfahren nach einem der Ansprüche 1 bis 8, wobei das Steuern des aus dem System ausgetragenen Produkts ein Steuern von zwei Variablen aus je Zyklus eingetragener kristallisierbarer Materialbeschickung, je Zyklus ausgetragenem Nebenprodukt und je Zyklus ausgetragenem Produkt aufweist.

10. Verfahren nach einem der Ansprüche 1 bis 9, wobei das Dosieren der gesteuerten Menge von Mutterlauge in Schritt (j) indirekt durch Dosieren von rekristallisierbarem Kristallmaterial gesteuert wird, das von jeder Stufe zu der nächstreineren Stufe überführt wird.

11. Verfahren nach einem der Ansprüche 1 bis 10, wobei das Steuern des aus dem System ausgetragenen Produkts ein Steuern von zwei Variablen aus je Zyklus eingetragener kristallisierbarer Materialbeschickung, je Zyklus ausgetragenem Nebenprodukt und je Zyklus ausgetragenem Produkt aufweist, und wobei das Dosieren der gesteuerten Menge von Mutterlauge in Schritt (j) indirekt durch Dosieren von rekristallisierbarem Kristallmaterial gesteuert wird, das von jeder Stufe zu der nächstreineren Stufe überführt wird.

12. Verfahren nach einem der Ansprüche 1 bis 11, ferner mit einem fremdstoffkonzentrierenden System mit mehreren Konzentrationsstufen zum Weiterverarbeiten des Nebenprodukts von Schritt (g), wobei das fremdstoffkonzentrierende System eine reinste Konzentrationsstufe und eine unreinste Konzentrationsstufe aufweist; wobei eine Beschickung in das fremdstoffkonzentrierende System in die reinste Konzentrationsstufe erfolgt, Nebenprodukt aus dem fremdstoffkonzentrierenden System aus der unreinsten Konzentrationsstufe stammt, und Konzentrationsprodukt aus dem fremdstoffkonzentrierenden System aus der reinsten Konzentrationsstufe stammt, und das Konzentrationsprodukt reiner als das Nebenprodukt von Schritt (g) ist; und wobei jede Konzentrationsstufe den kristallisierbaren Stoff löst, ihn rekristallisiert, in Kristalle und Mutterlauge trennt, eine gesteuerte Menge von Mutterlauge zu einer Stufe nächstniedrigerer Reinheit überführt und Kristalle zu einer Stufe nächstgrößerer Reinheit überführt.

13. Verfahren nach einem der Ansprüche 1 bis 12, wobei der Schritt des Überführens einer gesteuerten Menge von Mutterlauge aufweist: Bewegen von Mutterlauge zu einem Rückflußauffänger vor dem Kristallisierer (32) einer jeden solchen Stufe vor dem Schritt, der eine gesteuerte Menge von Mutterlauge bereitstellt, die die Kristalle der nächstunreineren Stufe wäscht.

14. Vorrichtung zum Hochreinigen kristallisierbarer Stoffe durch einen zyklischen mehrstufigen Rekristallisationsablauf mit:
a) mehreren Stufen (L, I1, I2, P), die Komponenten mit Sammelbehältern (21) für jede Stufe haben, wobei die Stufen über im wesentlichen duplizierte Zyklen arbeiten, die im wesentlichen gleichzeitig innerhalb jeder Stufe durchgeführt werden, und eine unreinste Stufe (L) und eine reinste Stufe (P) aufweisen;
b) einer Einrichtung zum Zugeben einer gesteuerten Menge von kristallisierbarem Stoff zu der Sammeleinrichtung der unreinsten Stufe (L);
c) einer Einrichtung zum Zugeben eines Lösungsmittels für einen kristallisierbaren Stoff zu der reinsten Stufe (P), wobei sich das Lösungsmittel von dem kristallisierbaren Stoff unterscheidet und ihn nicht enthält;
d) einer Einrichtung zum Lösen von kristallisierbarem Stoff in Mutterlauge, die das Lösungsmittel für ihn aufweist, um eine gesättigte neue Lösung innerhalb jedes Sammelbehälters (21) zu bilden;
e) einem Kristallisationsbehälter (22) zum Rekristallisieren im wesentlichen des gesamten kristallisierbaren Stoffs in jeder gesättigten neuen Lösung durch Senken der Temperatur jeder gesättigten neuen Lösung jeder Stufe auf eine ausgewählte Temperatur ohne Gefrieren, bei der der kristallisierbare Stoff aus der neuen Lösung auskristallisiert, um eine Menge von Kristallschlamm in jeder Stufe zu bilden, wobei der Kristallschlamm derart rekristallisierte Kristalle aufweist;
f) einem Trennbehälter (23) zum Trennen des Kristallschlamms jeder der Stufen in rekristallisierte Kristalle und Mutterlauge und zum Überführen der abgetrennten Mutterlauge zu einem Mutterlaugenauffänger jeder Stufe;
g) einem Rückflußbehälter (25, 26) jeder Stufe, wobei sich der Rückflußbehälter nach dem Mutterlaugenauffänger seiner Stufe befindet und zum Dosieren einer gesteuerten Menge von Mutterlauge von ihm dient, um dadurch eine gesteuerte Menge von Mutterlauge bereitzustellen;
h) einer Einrichtung zum Überführen der gesteuerten Menge von Mutterlauge jeder Stufe mit Ausnahme der unreinsten Stufe (L) zu der nächstunreineren Stufe und zum Waschen der rekristallisierten Kristalle dieser nächstunreineren Stufe mit Mutterlauge von einer reineren Stufe;
i) einer Einrichtung zum Überführen der gesteuerten Menge von Mutterlauge von der unreinsten Stufe und damit zum Bereitstellen einer gesteuerten Menge von Nebenprodukt;
j) einer Einrichtung zum Bewegen einer gesteuerten Menge der rekristallisierten Kristalle von dem Trennbehälter (23) mit Ausnahme jener der reinsten Stufe (P) zu dem Sammelbehälter (21) der nächstreineren Stufe;
k) einer Einrichtung zum Sammeln einer gesteuerten Menge der rekristallisierten Kristalle von dem Trennbehälter (23) der reinsten Stufe (P) als eine gesteuerte Menge von hochgereinigtem Kristallprodukt;
l) einer Einrichtung zum Leiten von restlicher Mutterlauge von dem Mutterlaugenauffänger jeder Stufe zu dem Sammler der gleichen Stufe, wobei die restliche Mutterlauge Mutterlauge ist, die jene gesteuerte Menge von Mutterlauge übersteigt, die durch die Rückflußeinrichtung dosiert wird;
m) einer Einrichtung zum Steuern des Rückflußverhältnisses der mehrstufigen Vorrichtung, wobei die Steuereinrichtung die Rückflußeinrichtung und die Einrichtung zum Sammeln der gesteuerten Menge von hochgereinigtem Produkt aufweist, und die Steuereinrichtung ferner eine Einrichtung zum Aufrechterhalten stationärer Bedingungen innerhalb und zwischen jeder Stufe des Systems aufweist.

15. Vorrichtung nach Anspruch 14, wobei jede Einrichtung zum Überführen der gesteuerten Menge von Mutterlauge zu der nächstunreineren Stufe eine Einrichtung zum Waschflüssigkeitsüberführen einer gesteuerten Menge von Mutterlauge, die zu dem Mutterlaugenauffänger (25, 26, 35) anderer Stufen als der unreinsten Stufe geleitet wird, zu der Trenneinrichtung der nächstunreineren Stufe ist.

16. Vorrichtung nach Anspruch 14 oder 15, ferner mit einer Einrichtung zum Aufrechterhalten im wesentlichen gleicher Temperaturbedingungen innerhalb jeder jeweiligen Komponente jeder Stufe.

17. Vorrichtung nach Anspruch 14, 15 oder 16, wobei die Vorrichtung zwischen zwei und etwa zehn der Stufen aufweist.

18. Vorrichtung nach einem der Ansprüche 14 bis 17, wobei die Kristallbewegungseinrichtung einen Kristallauffangbehälter separat von der Trenneinrichtung aufweist.

19. Vorrichtung nach einem der Ansprüche 14 bis 18, ferner mit einer Einrichtung zum Einstellen der relativen Dichte des neuen Lösungsschlamms innerhalb jeder Sammeleinrichtung.

20. Vorrichtung nach einem der Ansprüche 14 bis 19, wobei die stationäre Bedingungen aufrechterhaltende Einrichtung aufweist: eine Einrichtung zum Steuern der Überführungseinrichtung, die Einrichtung zum Waschflüssigkeitsüberführen, die Bewegungseinrichtung und die Sammeleinrichtung, wodurch jede Einrichtung eine Bewegung im wesentlichen gleicher Mengen jeweiliger Materialien zwischen jeder der mehreren Stufen steuert.

21. Vorrichtung nach einem der Ansprüche 14 bis 20, ferner mit einem fremdstoffkonzentrierenden System mit mehreren Konzentrationsstufen zum Weiterverarbeiten des Nebenprodukts von der unreinsten Stufe, wobei das fremdstoffkonzentrierende System aufweist: eine reinste Konzentrationsstufe und eine unreinste Konzentrationsstufe, eine Beschickungseingabeeinrichtung zum Leiten des Nebenprodukts der unreinsten Stufe in die reinste Konzentrationsstufe, eine Ausgabeeinrichtung zum Entfernen von Nebenprodukt von der unreinsten Konzentrationsstufe und eine Produktausflußeinrichtung zum Entfernen von Konzentrationsprodukt von der reinsten Konzentrationsstufe, wobei das Konzentrationsprodukt reiner als das Nebenprodukt von der unreinsten Stufe ist; und
wobei jede der Konzentrationsstufen aufweist: eine Einrichtung zum Lösen des Nebenprodukts der unreinsten Stufe, eine Einrichtung zu seinem Rekristallisieren, eine Einrichtung zu seinem Trennen in Kristalle und Mutterlauge, eine Einrichtung zum Überführen einer gesteuerten Menge von Mutterlauge zu einer Stufe nächstniedrigerer Reinheit und eine Einrichtung zum Überführen von Kristallen zu einer Stufe nächstgrößerer Reinheit.

22. Vorrichtung nach einem der Ansprüche 14 bis 21, wobei die Überführungseinrichtung einen Rückflußauffangbehälter (26, 36) separat von dem Mutterlaugenauffänger (25, 35) aufweist.

## Revendications

1. Procédé pour purifier de manière poussée des substances cristallisables par une procédure de recristallisation à étages multiples qui comprend de maîtriser les conditions de rapport de reflux, comprenant de :
fournir une pluralité d'étages ayant des cuves avec des substances cristallisables à l'intérieur et faire fonctionner lesdits étages en réalisant une séquence d'étapes de manière cyclique par l'intermédiaire d'une pluralité de cycles sensiblement doublés conduits sensiblement simultanément pendant chaque étape de sorte que la substance cristallisable à chaque étage est dissoute et recristallisée dans chacun desdits étages, l'un desdits étages étant un étage le moins pur où on ajoute une quantité maîtrisée de substance cristallisable à purifier de manière poussée de l'extérieur d'une pluralité d'étages en tant qu'alimentation dans une cuve de l'étage le moins pur, un autre desdits étages étant l'étage le plus pur où le solvant qui ne contient pas de substance cristallisable et est différent de ladite substance est ajouté à l'étage le plus pur de l'extérieur de la pluralité des étages, la séquence des étapes comprenant de :
(a) dissoudre dans une cuve collectrice (21) de la substance cristallisable à recristalliser, ladite substance cristallisable pour l'étage le moins pur (L) étant ladite substance cristallisable alimentée pour être purifiée de manière poussée, et ladite substance cristallisable pour l'étage ou les étages restants étant recristallisée dans un étage suivant moins pur, où cette substance cristallisable et liqueur mère de l'étage soumis à l'étape de dissolution sont réunis audit étage, la liqueur mère étant composée principalement dudit solvant, pour ainsi dissoudre la substance cristallisable dans le solvant et former une nouvelle solution séparée saturée dans la cuve collectrice, ladite nouvelle solution saturée séparée étant une solution où toute la substance cristallisable est dissoute dans ledit solvant ;
(b) transférer ladite nouvelle solution saturée séparée de chaque étage de la cuve collectrice (21) vers une cuve de cristallisation (22) ;
(c) recristalliser ladite substance cristallisable dans la cuve de cristallisation (22) de chaque étage, ladite étape de recristallisation comprenant d'abaisser la température de ladite nouvelle solution séparée saturée à une température choisie à laquelle sa substance cristallisable recristallise sans geler le liquide de façon à former ainsi une certaine quantité de pâte de cristaux à chaque étage, ladite pâte de cristaux comprenant ainsi des cristaux à cristalliser ;
(d) transférer ladite pâte de cristaux dans une cuve séparateur (23) de cet étage ;
(e) séparer dans la cuve séparateur (23) ladite pâte de cristaux en des cristaux recristallisés séparés et une liqueur mère séparée ;
(f) transférer une quantité maîtrisée de ladite liqueur mère séparée décantée à l'étape (e) dans une cuve de reflux (25, 26) de cet étage, et transférer le reste de ladite liqueur mère séparée vers la cuve collectrice (21) de cet étage, où sensiblement seulement lesdits cristaux recristallisés séparés restent dans la cuve de séparateur (23) ;
(g) quand ledit étage est ledit étage le moins pur (L) ; ladite quantité maîtrisée de liqueur mère séparée de l'étape (f) est un sous-produit soutiré de la pluralité des étages ;
(h) quand ledit étage (P, I2, I1) est un étage différent de l'étage le moins pur (L), la quantité maîtrisée de liqueur mère fournie dans la cuve de reflux (26) à l'étape (f) est transférée à la cuve séparateur (23) de l'étage moins pur suivant (I2, I1, L) où lesdits cristaux recristallisés séparés dans ladite cuve de séparateur (23) sont lavés avec de la liqueur mère plus pure que la liqueur mère dudit étage suivant moins pur ;
(i) transférer une quantité maîtrisée desdits cristaux recristallisés séparés à l'étape (e) dans la cuve collectrice (21) de l'étage plus pur suivant, dont les cristaux recristallisés sont la substance cristallisable de l'étape (a) sauf que ladite étape (i) transférant l'étape de l'étage le plus pur transfère la quantité maîtrisée des cristaux recristallisés hors de la pluralité des étages sous forme de produit cristallisé recristallisé très pur, et transférer tout reste desdits cristaux recristallisés séparés à l'étape (e) vers la cuve collectrice (21) de cet étage ; et
(j) maîtriser le rapport de reflux de la procédure de recristallisation en plusieurs étages en dosant la quantité maîtrisée (26) de liqueur mère qui est transférée pendant l'étape (f) et en maîtrisant le produit de cristaux recristallisés transférés depuis l'étage le plus pur (P) pendant l'étape (i).

2. Procédé selon la revendication 1, où ledit produit de cristaux a une pureté de 99,999%.

3. Procédé selon la revendication 1 ou 2, où les conditions de températures sont sensiblement les mêmes à chaque dit étage.

4. Procédé selon la revendication 1, 2 ou 3, où le système comprend entre deux et environ dix étages.

5. Procédé selon l'une quelconque des revendications 1 à 4, où chaque quantité maîtrisée de liqueur mère et de cristaux qui se déplacent entre les étages est sensiblement la même indépendamment de l'étage d'ou vient ou vers lequel s'effectue le déplacement.

6. Procédé selon l'une quelconque des revendications 1 à 5, qui comprend en outre de transférer les cristaux séparés à l'étape (e) dans un récepteur de cristaux (24) pour réaliser l'étape (i).

7. Procédé selon l'une quelconque des revendications 1 à 6, qui comprend en outre d'ajuster le poids spécifique de la nouvelle solution dans chaque collecteur avant l'étape (c).

8. Procédé selon l'une quelconque des revendications 1 à 7, où ladite étape de maîtrise du rapport de reflux comprend d'ajouter, d'éliminer et/ou de transférer les mêmes quantités de cristaux alimentés de matériau cristallisable, de liqueur mère, de sous-produit, de liquide de rinçage et de produit dans chaque étage du système et dans chacun de ses cycles, et de maintenir les mêmes conditions de température à chaque étage et chaque cycle.

9. Procédé selon l'une quelconque des revendications 1 à 8, où ladite maîtrise du produit soutiré du système comprend de maîtriser deux quelconques des alimentations de matériau cristallisable introduit dans chaque cycle, de sous-produit soutiré de chaque cycle et de produit soutiré à chaque cycle.

10. Procédé selon l'une quelconque des revendications 1 à 9, où ladite étape (j) de dosage de ladite quantité maîtrisée de liqueur mère est maîtrisée indirectement en dosant le matériau de cristal recristallisable qui est transféré de chaque étage à l'étage suivant plus pur.

11. Procédé selon l'une quelconque des revendications 1 à 10, où ladite maîtrise du produit soutiré du système comprend de maîtriser deux quelconques des alimentations de matériau cristallisable introduit dans chaque cycle, de sous-produit soutiré dans chaque cycle et de produit soutiré dans chaque cycle, et où ladite étape (j) de dosage de ladite quantité maîtrisée de liqueur mère est maîtrisée indirectement en dosant le matériau de cristal recristallisable qui est transféré de chaque étage à l'étage suivant plus pur.

12. Procédé selon l'une quelconque des revendications 1 à 11, comprenant en outre un système de concentration d'impuretés ayant une pluralité d'étages de concentration pour encore traiter ledit sous-produit de l'étape (g), ledit système de concentration d'impuretés comprenant un étage de concentration le plus pur et un étage de concentration le moins pur ; où l'alimentation dans le système de concentration d'impuretés est dans l'étage de concentration le plus pur, le sous-produit provenant du système de concentration d'impuretés provient de l'étage de concentration le moins pur, et le produit de concentration provenant du système de concentration d'impuretés provient de l'étage de concentration le plus pur, ledit produit de concentration étant plus pur que le sous-produit de ladite étape (g) ; et où chaque dit étage de concentration dissout la substance cristallisable, la recristallise, la sépare en cristaux et liqueur mère, transfère une quantité maîtrisée de liqueur mère vers un étage de pureté moindre suivant et transfère les cristaux vers l'étage suivant de plus grande pureté.

13. Procédé selon l'une quelconque des revendications 1 à 12, où ladite étape de transfert d'une quantité maîtrisée de liqueur mère comprend de déplacer la liqueur mère vers un récepteur de reflux en amont du cristalliseur (32) de chaque étage de ce type avant ladite étape qui fournit une quantité maîtrisée de liqueur mère qui lave les cristaux de l'étage suivant moins pur.

14. Appareil pour purifier de manière poussée des substances cristallisables par une procédure de recristallisation à plusieurs étages cycliques, comprenant :
a) une pluralité d'étages (L, I1, I2, P) ayant des composants comprenant des cuves collectrices (21) pour chaque étage, lesdits étages fonctionnant par des cycles sensiblement doublés fonctionnant sensiblement simultanément à chaque étage et comprenant un étage le moins pur (L) et un étage le plus pur (P) ;
b) des moyens pour ajouter une quantité maîtrisée de substance cristallisable dans les moyens collecteurs de l'étage le moins pur (L) ;
c) des moyens pour ajouter un solvant à la substance cristallisable audit étage le plus pur (P), ledit solvant étant différent de et ne contient pas de la substance cristallisable ;
d) des moyens pour dissoudre de la substance cristallisable dans la liqueur mère comprenant ledit solvant prévu pour former une nouvelle solution saturée dans chaque cuve collectrice (21) ;
e) une cuve cristalliseur (22) pour recristalliser sensiblement toute la substance cristallisable dans chaque nouvelle solution saturée en abaissant la température de chaque nouvelle solution saturée de chaque étape à une température sélectionnée sans geler le liquide et où la substance cristallisable cristallise à partir de la nouvelle solution de façon à former une quantité de pâte de cristaux dans chaque étage indiqué, ladite pâte de cristaux comprenant les cristaux ainsi recristallisés ;
f) une cuve séparateur (23) pour séparer ladite pâte de cristaux de chacun desdits étages en les cristaux recristallisés et la liqueur mère et pour transférer la liqueur mère séparée dans le récepteur de liqueur mère de chaque dit étage ;
g) une cuve de reflux (25, 26) de chacun desdits étages, ladite cuve de reflux étant en aval de et servant à doser une quantité bien maîtrisée de liqueur mère provenant du récepteur de liqueur mère de son étage pour fournir ainsi une quantité maîtrisée de liqueur mère ;
h) des moyens pour transférer ladite quantité maîtrisée de liqueur mère de chaque étage sauf pour l'étage le moins pur (L) vers l'étage moins pur suivant et pour laver lesdits cristaux recristallisés de cet étage moins pur suivant avec la liqueur mère d'un étage plus pur ;
i) des moyens pour transférer ladite quantité maîtrisée de liqueur mère de l'étage le moins pur et pour ainsi fournir une quantité maîtrisé de sous-produit ;
j) des moyens pour déplacer une quantité maîtrisée des cristaux recristallisés à partir de la cuve de séparateur (23), sauf ceux de l'étage le plus pur (P) vers ladite cuve collectrice (21) ou l'étage plus pur suivant ;
k) des moyens pour recueillir une quantité maîtrisée des cristaux recristallisés à partir de ladite cuve de séparateur (23) ou de l'étage le plus pur (P) en tant que quantité maîtrisée de produit cristallisé très purifié ;
l) des moyens pour faire passer la liqueur mère résiduelle dudit récepteur de liqueur mère de chaque étage dans le collecteur du même étage, la liqueur mère résiduelle étant la liqueur mère en excès de cette quantité maîtrisée de liqueur mère dosée par lesdits moyens de reflux ;
m) des moyens pour maîtriser le rapport de reflux de l'appareil à plusieurs étages, et des moyens de maîtrise comprenant lesdits moyens de reflux et lesdits moyens de réception de la quantité maîtrisée de produit très purifié, lesdits moyens de maîtrise comprenant en outre des moyens pour maintenir les conditions d'état d'équilibre dans et entre chaque étage dudit système.

15. Appareil selon la revendication 14, où chacun desdits moyens de transfert de ladite quantité maîtrisée de liqueur mère vers l'étage moins pur suivant est un moyen de transfert de rinçage d'une quantité maîtrisée de liqueur mère vers le récepteur de liqueur mère (25, 26, 35) des étages autres que ledit étage le moins pur vers les moyens de séparation de l'étage moins pur suivant.

16. Appareil selon la revendication 14 ou 15, qui comprend en outre des moyens pour maintenir des conditions de températures sensiblement égales dans chaque composant respectif de chaque dit étage.

17. Appareil selon la revendication 14, 15 ou 16, où l'appareil comprend entre deux et environ dix desdits étages.

18. Appareil selon l'une quelconque des revendications 14 à 17, où lesdits moyens de transfert des cristaux comprennent une cuve réceptrice de cristaux séparée desdits moyens de séparation.

19. Appareil selon l'une quelconque des revendications 14 à 18, qui comprend en outre des moyens pour régler le poids spécifique de ladite nouvelle pâte dans chacun des moyens collecteurs.

20. Appareil selon l'une quelconque des revendications 14 à 19, où lesdits moyens maintenant l'état d'équilibre comprennent des moyens pour maîtriser lesdits moyens de transfert, lesdits moyens de transfert de rinçage, lesdits moyens de déplacement et lesdits moyens de collecte, où chacun desdits moyens maîtrise le déplacement de quantités sensiblement égales de chacun des matériaux respectifs entre chacun desdits étages.

21. Appareil selon l'une quelconque des revendications 14 à 20, qui comprend en outre un système de concentration d'impuretés ayant une pluralité d'étages de concentration pour encore traiter le sous-produit provenant dudit étage le moins pur, ledit système de concentration d'impuretés comprend un étage de concentration le plus pur et un étage de concentration le moins pur, des moyens d'introduction du produit alimenté pour faire passer le sous-produit dudit étage le moins pur dans l'étage de concentration le plus pur, des moyens de soutirage pour soutirer le sous-produit dudit étage de concentration le moins pur, et des moyens de déversement du produit pour éliminer le produit de concentration de l'étage de concentration le plus pur, ledit produit de concentration étant plus pur que ledit sous-produit provenant de l'étage le moins pur ; et
où chacun desdits étages de concentration comprend des moyens pour dissoudre le sous-produit de l'étage le moins pur, des moyens pour le recristalliser, des moyens pour le séparer en cristaux et liqueur mère, des moyens pour transférer une quantité maîtrisée de liqueur mère vers un étage suivant de pureté inférieure, et des moyens pour transférer les cristaux vers un étage suivant plus grande pureté.

22. Appareil selon l'une quelconque des revendications 14 à 21, où lesdits moyens de transfert comprennent une cuve réceptrice de reflux (26, 36) séparée dudit récepteur (25, 35) de liqueur mère.
